# EUROPEAN PATENT APPLICATION

(11) **EP 2 661 161 A1**
(43) Date of publication of application: **06.11.2013**
(21) Application number: 12166828.9
(22) Date of filing: 04.05.2012
(51) Int. Cl.: H05K 5/06

(54) **Sealing arrangment for cable entry of an overmolded electronic component**

(71) Applicant: Tyco Electronics Belgium EC BVBA, 8020 Oostkamp (BE)
(72) Inventor: De Boever, Geert, 8810 Lichtervelde (BE); Devos, Peter, 9032 Wondelgem (BE); van Cauwenberge, Jan, B 9880 Aalter (BE); De Brauwer, Hans, 8340 Damme (BE)
(74) Representative: Patentanwaltskanzlei WILHELM & BECK

(57) **Abstract**

A litz cable comprises a plurality of wire strands. A grommet is arranged around the cable. A plastic material is arranged on the grommet.

## Description

The present invention relates to a litz cable according to claim 1 and to a method for producing a watertight cable according to claim 11.

Litz cables or litz wires are cables that comprise a plurality of thin wire strands that may or may not be individually insulated. The wire strands are usually twisted or woven together and provided with a common insulation. Litz cables are often used in electronics to carry alternating currents.

It is known in the state of the art to overmold electronic components with plastic materials. It is also known to provide electronic components with cables for supplying electric power to the component. Overmolding of the electronic component includes overmolding of sections of the cable in this case. This results in an electric cable leading into an overmolded electronic component.

Experiments have shown that partially overmolded electric cables are not sufficiently watertight. Water and other liquids and gases may creep along the cable into the inside of the overmolded electronic component.

It is an object of the present invention to provide an improved watertight litz cable. This objective is achieved by a litz cable according to claim 1. It is a further object of the present invention to provide a method for producing a watertight cable. This objective is achieved by a method according to claim 11. Preferred embodiments are disclosed in the dependent claims.

A litz cable according to the invention comprises a plurality of wire strands. A grommet is arranged around the cable. A plastic material is arranged on the grommet. Advantageously, this litz cable may comprise IP 69 watertightness.

In a preferred embodiment of the litz cable, the grommet comprises an amorphous copolyamide PA6/66/136. Advantageously, such copolyamide adheres well to the cable and to the plastic material, providing a reliable sealing against external substances.

In an especially preferred embodiment of the litz cable, the grommet comprises Ultramid® Seal-Fit or Macromelt®. Advantageously, these commercially available materials have proven to comprise suitable properties for sealing the litz cable.

In a preferred embodiment of the litz cable, the grommet is molded around the cable. Advantageously, molding allows for a simple and cost-efficient production of the litz cable.

It is also preferred that the plastic material is molded over the grommet. Advantageously, molding the plastic material allows for a simple and cost-efficient production of the litz cable.

In one embodiment of the litz cable, the plastic material overlaps the grommet in a longitudinal direction of the cable. Advantageously, the plastic material then serves for mechanically protecting the grommet.

It is preferred that the plastic material is in contact with the cable. Advantageously, the plastic material then completely surrounds the grommet, thereby protecting the grommet against damage.

In one embodiment of the litz cable, a cable insulation is arranged between the wire strands of the litz cable and the grommet. Advantageously, the cable insulation does not need to be compliant with the plastic material.

According to an alternative embodiment of the litz cable, a tin-plating is arranged between the wire strands and the grommet. Advantageously, the litz cable does not need to comprise a cable insulation in this embodiment.

In an especially preferred embodiment of the litz cable, tin is arranged between individual wire strands of the litz cable. Advantageously, the wire strands of the litz cable then form one homogeneous block, preventing liquids and air from creeping along the cable between the individual wire strands.

According to the invention, a method for producing a watertight cable comprises steps for providing a litz cable having a plurality of wire strands, molding a grommet around the cable and molding a plastic material over the grommet. Advantageously, this method allows for a cost-effective production of a watertight litz cable.

In a preferred embodiment of the method, the grommet is molded using an amorphous copolyamide PA6/66/136. Advantageously, such copolyamide adheres well to both the cable and the plastic material, providing a reliable sealing.

In an especially preferred embodiment of the method, the grommet is molded using Ultramid® Seal-Fit or Macromelt®. Advantageously, these two commercially available materials have proven to provide suitable properties for sealing the litz cable.

In one embodiment, the litz cable is provided with a cable insulation, wherein the grommet is molded around the cable insulation. Advantageously, the overmold plastic does not need to compliant with the cable insulation as the grommet serves as a connection between the cable insulation and the overmold plastic.

According to an alternative embodiment of the method, the litz cable is provided without a cable insulation, wherein the litz cable is soldered before molding the grommet around the cable. Advantageously, this method allows for producing a watertight litz cable without a cable insulation.

The invention will now be explained in more detail with reference to the figures in which:
Figure 1 shows a watertight litz cable with a cable insulation;
Figure 2 shows a watertight litz cable without a cable insulation;
Figure 3 shows a watertight litz cable with a partially removed cable insulation; and
Figure 4 shows a schematic flow diagram of a method for producing a litz cable.

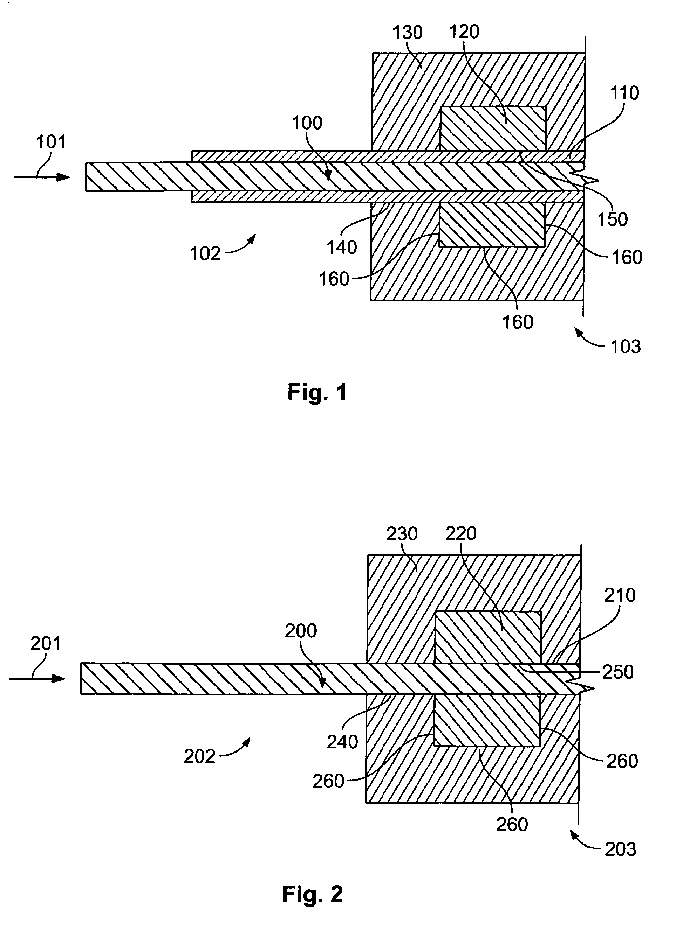

Figure 1 shows a schematic sectional view of a litz cable 100. The litz cable 100 may for example be used to carry an alternating current.

The litz cable 100 comprises a plurality of wire strands that are not individually shown in figure 1. The wire strands may or may not be individually insulated from each other. The wire strands are twisted or woven together to form a conductive core of the litz cable 100. The litz cable 100 extends in a longitudinal direction 101.

The litz cable 100 comprises a cable insulation 110 that envelops the conductive core of the litz cable 100. The cable insulation 110 comprises an electrically insulating material.

The litz cable 100 is connected to an electronic component that is not shown in figure 1. The electronic component is arranged inside an overmold plastic 130. The litz cable 100 reaches from outside the overmold plastic 130 to the electronic component inside the overmold plastic 130. Consequently, the litz cable 100 comprises an outer section 102 and an inner section 103 that are arranged one after another in the longitudinal direction 101 of the litz cable 100. The outer section 102 is arranged outside the overmold plastic 130. The inner section 103 is arranged inside the overmold plastic 130.

A grommet 120 is arranged around the cable insulation 110. In the embodiment shown in Figure 1, the grommet 120 comprises the shape of a ring or a hollow cylinder. In alternative embodiments, the grommet 120 may comprise a square cross section or another shape. Preferably, the grommet 120 is molded over the cable insulation 110.

The overmold plastic 130 is arranged on the grommet 120 and on the cable insulation 110. The overmold plastic 130 overlaps the grommet 120 in the longitudinal direction 101 of the litz cable 100 such that the overmold plastic 130 is both in contact with the grommet 120 and with the cable insulation 110. The overmold plastic 130 is preferably molded over the grommet 120 and the cable insulation 110.

The grommet 120 comprises a material that sticks well to both the cable insulation 110 and the overmold plastic 130. Preferably, the grommet 120 comprises an amorphous copolyamide PA6/66/136. The grommet 120 may preferably comprise Ultramid® Seal-Fit by BASF or Macromelt® by Henkel.

A first interface 140 is formed between the overmold plastic 130 and the cable insulation 110. A second interface 150 is formed between the cable insulation 110 and the grommet 120. A third interface 160 is formed between the grommet 120 and the overmold plastic 130.

The overmold plastic 130 is not necessarily compliant with the material of the cable insulation 110. Consequently, the overmold plastic 130 may not stick well to the cable insulation 110. This results in the first interface 130 between the overmold plastic 130 and the cable insulation 110 not providing a reliable seal. Consequently, liquids such as water or gases such as air may creep along the first interface 140 between the cable insulation 110 and the overmold plastic 130 in the longitudinal direction 101.

The grommet 120 sticks well to the cable insulation 110 through a combination of adhesion and compression. Consequently, the second interface 150 between the grommet 120 and the cable insulation 110 provides a watertight seal. The overmold plastic 130 also sticks well to the grommet 120. Consequently, the third interface 160 between the overmold plastic 130 and the grommet 120 also provides a reliable watertight seal. Consequently, any gases or liquids that have crept along the first interface 140 are blocked at the second interface 150 and the third interface 160. The second interface 150 and the third interface 160 prevent gases and liquids from entering further into the electronic component along the inner section 103 of the litz cable 100. The litz cable 100 is thus watertight.

Figure 2 shows a schematic sectional view of a second litz cable 200. The litz cable 200 comprises a plurality of wire strands that are not individually shown in figure 2. The wire strands may or may not be individually insulated from each other. The wire strands are twisted or woven together to form a conductive core of the litz cable 200. In contrast to the first litz cable 100 shown in figure 1, the second litz cable 200 shown in figure 2 does not comprise a cable insulation. The litz cable 200 extends in a longitudinal direction 201.

The litz cable 200 is again connected to an electronic component that is not shown in figure 2. The electronic component is housed inside an overmold plastic 230. The litz cable 200 extends from outside the overmold plastic 230 into the overmold plastic 230 where it is connected to the electronic component. Accordingly, the litz cable 200 comprises an outer section 202 and an inner section 203 along its longitudinal direction 201. The inner section 203 is arranged inside the overmold plastic 230.

The litz cable 200 has been soldered to comprise a tin-plating 210 on the outer surface of the litz cable 200. During the soldering of the litz cable 200, tin has also entered the core of the litz cable 200 such that tin is arranged between the individual wire strands of the litz cable 200. The litz wires of the litz cable 200 consequently form a homogeneous block.

A grommet 220 is arranged around the litz cable 200. In the embodiment shown in Figure 2, the grommet 220 comprises the shape of a ring or a hollow cylinder. In alternative embodiments, the grommet 220 may comprise a square cross section or another shape. Preferably, the grommet 220 has been molded around the litz cable 200.

The overmold plastic 230 is arranged on the grommet 220 and the tin-plating 210 of the litz cable 200. In the longitudinal direction 201, the overmold plastic 230 overlaps the grommet 220 such that the overmold plastic 230 is both in contact with the grommet 220 and with the tin-plating 210 of the litz cable 200.

A first interface 240 is formed between the overmold plastic 230 and the tin-plating 210 of the litz cable 200. A second interface 250 is formed between the grommet 220 and the tin-plating 210 of the litz cable 200. A third interface 260 is formed between the overmold plastic 230 and the grommet 220.

Water and gases are prevented from creeping along the litz cable 200 between the individual litz wires of the litz cable 200 because the litz wires of the litz cable 200 are soldered together. Liquids and gases may, however, creep along the first interface 240 between the overmold plastic 230 and the tin-plating 210 because the overmold plastic 230 may not stick well to the tin-plating 210. The overmold plastic 230 does, however, stick well to the grommet 220. The grommet 220 also sticks well to the tin-plating 210 through a combination of adhesion and compression. Consequently, both the second interface 250 and the third interface 260 provide watertight seals that prevent liquids such as water and gases such as air from entering further along the litz cable 200 in the longitudinal direction 201. Liquids and gases that have entered into the overmold plastic 230 along the first interface 240 are blocked from entering further inside the overmold plastic 230 along the second interface 250 and the third interface 260.

Preferably, the grommet 220 has been molded around the litz cable 200. The grommet 220 preferably comprises an amorphous copolyamide PA6/66/136. The grommet 220 may preferably comprise Ultramid® Seal-Fit by BASF or Macromelt® by Henkel. The overmold plastic 230 has preferably been molded over the grommet 220 and the litz cable 200.

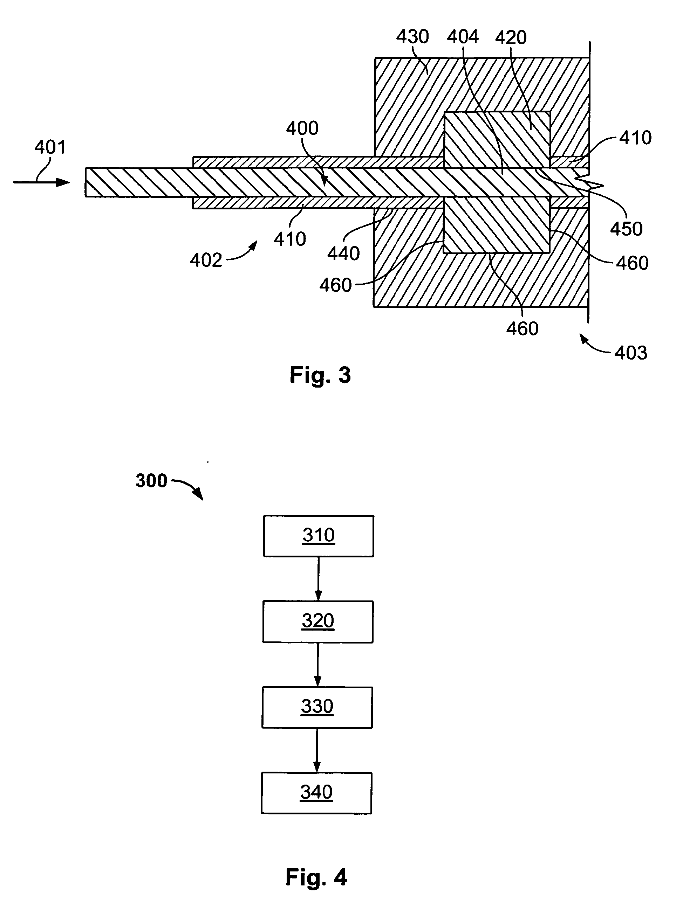

Figure 3 shows a schematic sectional view of a third litz cable 400. The litz cable 400 comprises a plurality of wire strands that are not individually shown in figure 3. The wire strands may or may not be individually insulated from each other. The wire strands are twisted or woven together to form a conductive core of the litz cable 400. The litz cable 400 extends in a longitudinal direction 401.

The third litz cable 400 comprises a cable insulation 410 that envelops the conductive core of the litz cable 400. The cable insulation 410 comprises an electrically insulating material.

The litz cable 400 is again connected to an electronic component that is not shown in figure 3. The electronic component is housed inside an overmold plastic 430. The litz cable 400 extends from outside the overmold plastic 430 into the overmold plastic 430 where it is connected to the electronic component. Accordingly, the litz cable 400 comprises an outer section 402 and an inner section 403 along its longitudinal direction 401. The inner section 403 is arranged inside the overmold plastic 430.

In a stripped section 404 of the litz cable 400, the cable insulation 410 has been removed. The stripped section 404 is part of the inner section 403. The litz cable 400 may have been soldered to comprise a tin-plating on the outer surface of the litz cable 400 in the stripped section 404.

A grommet 420 is arranged around the stripped section 404 of the litz cable 400. Preferably, the grommet 420 has been molded around the litz cable 400.

The overmold plastic 430 is arranged on the grommet 420 and on the cable insulation 410. The overmold plastic 430 overlaps the grommet 420 in the longitudinal direction 401 of the litz cable 400 such that the overmold plastic 430 is both in contact with the grommet 420 and with the cable insulation 410. The overmold plastic 430 is preferably molded over the grommet 420 and the cable insulation 410.

A first interface 440 is formed between the overmold plastic 430 and the cable insulation 410. A second interface 450 is formed between the grommet 420 and the litz cable 400 or between the grommet 420 and the tin-plating 410 of the litz cable 400. A third interface 460 is formed between the grommet 420 and the overmold plastic 430.

Figure 4 shows a schematic flow diagram of a method 300 for producing a watertight litz cable.

In a first method step 310, a litz cable having a plurality of wire strands is provided. The litz cable may be provided with or without a cable insulation.

In case the cable has been provided without a cable insulation in the first method step 310, the cable is soldered in a second method step 320. The soldering is performed such that a tin-plating forms on an outer surface of the cable. Preferably, the soldering is also performed such that tin enters the cable and remains between the individual wire strands of the litz cable. If the cable has been provided with a cable insulation in the first method step 310, the second method step 320 is skipped.

In a third method step 330, a grommet is molded around the cable. The grommet is preferably molded using an amorphous copolyamide PA6/66/136 such as Ultramid® Seal-Fit or Macromelt®.

In a fourth method step 340, the cable and the grommet are overmolded using an overmold plastic material. The overmold plastic is preferably arranged such that the overmold plastic overlaps the grommet in the longitudinal direction of the litz cable. The overmold plastic then covers the grommet entirely.

### Reference symbols

- 100: litz cable
- 101: longitudinal direction
- 102: outer section
- 103: inner section
- 110: cable insulation
- 120: grommet
- 130: overmold plastic
- 140: first interface
- 150: second interface
- 160: third interface

- 200: litz cable
- 201: longitudinal direction
- 202: outer section
- 203: inner section
- 210: tin plating
- 220: grommet
- 230: overmold plastic
- 240: first interface
- 250: second interface
- 260: third interface

- 300: method
- 310: providing a cable
- 320: soldering
- 330: overmolding the cable
- 340: overmolding the grommet

- 400: litz cable
- 401: longitudinal direction
- 402: outer section
- 403: inner section
- 404: stripped section
- 410: cable insulation
- 420: grommet
- 430: overmold plastic
- 440: first interface
- 450: second interface
- 460: third interface

## Claims

1. A litz cable (100, 200)
comprising a plurality of wire strands,
wherein a grommet (120, 220) is arranged around the cable (100, 200),
wherein a plastic material (130, 230) is arranged on the grommet (120, 220).

2. The litz cable (100, 200) according to claim 1,
wherein the grommet (120, 220) comprises an amorphous copolyamide PA6/66/136.

3. The litz cable (100, 200) according to any one of claims 1 or 2,
wherein the grommet (120, 220) comprises Ultramid® Seal-Fit or Macromelt®.

4. The litz cable (100, 200) according to any one of the previous claims,
wherein the grommet (120, 220) is molded around the cable (100, 200).

5. The litz cable (100, 200) according to any one of the previous claims,
wherein the plastic material (130, 230) is molded over the grommet (120, 220).

6. The litz cable (100, 200) according to any one of the previous claims,
wherein the plastic material (130, 230) overlaps the grommet (120, 220) in a longitudinal direction (101, 201) of the cable (100, 200).

7. The litz cable (100, 200) according to claim 6,
wherein the plastic material (130, 230) is in contact with the cable (100, 200).

8. The litz cable (100) according to any one of the previous claims,
wherein a cable insulation (110) is arranged between the wire strands and the grommet (120).

9. The litz cable (200) according to any one of claims 1 to 7,
wherein a tin plating (210) is arranged between the wire strands and the grommet (220).

10. The litz cable (200) according to claim 9,
wherein tin is arranged between individual wire strands of the litz cable (200).

11. A method for producing a watertight cable (100, 200), the method comprising the following steps:
- Providing a litz cable (100, 200) having a plurality of wire strands;
- Molding a grommet (120, 220) around the cable (100, 200) ;
- Molding a plastic material (130, 230) over the grommet (120, 220).

12. The method according to claim 11,
wherein the grommet (120, 220) is molded using an amorphous copolyamide PA6/66/136.

13. The method according to any one of claims 11 or 12,
wherein the grommet (120, 220) is molded using Ultramid® Seal-Fit or Macromelt®.

14. The method according to any one of claims 11 to 13,
wherein the litz cable (100) is provided with a cable insulation (110),
wherein the grommet (120) is molded around the cable insulation (110).

15. The method according to any one of claims 11 to 13,
wherein the litz cable (200) is provided without a cable insulation,
wherein the litz cable (200) is soldered before molding the grommet (220) around the cable (200).
